Europäisches Patentamt

European Patent Office

Office européen des brevets

(19)

(11) Veröffentlichungsnummer: **0 162 373**
**B1**

(12) # EUROPÄISCHE PATENTSCHRIFT

(45) Veröffentlichungstag der Patentschrift:
16.09.87

(51) Int. Cl.⁴: **H 02 B 1/04**

(21) Anmeldenummer: **85105650.7**

(22) Anmeldetag: **08.05.85**

(54) **Aus einzelnen Baugruppen zusammengesetzte elektrische Anlage.**

(30) Priorität: **21.05.84 DE 3418902**

(43) Veröffentlichungstag der Anmeldung:
**27.11.85 Patentblatt 85/48**

(45) Bekanntmachung des Hinweises auf die Patenterteilung:
**16.09.87 Patentblatt 87/38**

(84) Benannte Vertragsstaaten:
**AT BE CH DE FR GB IT LI SE**

(56) Entgegenhaltungen:
**DE - A - 1 815 041**
**DE - A - 2 810 071**
**DE - B - 1 180 021**

(73) Patentinhaber: **Siemens Aktiengesellschaft Berlin und München, Wittelsbacherplatz 2, D-8000 München 2 (DE)**

(72) Erfinder: **Meusel, Otto, Aufsessstrasse 18, D-8520 Erlangen (DE)**
Erfinder: **Münch, Heinz-Dieter, Seb.-Regler-Strasse 49, D-8450 Amberg (DE)**
Erfinder: **Seidel, Siegfried, Dipl.-Ing., Friedlandstrasse 26, D-8450 Amberg (DE)**
Erfinder: **Deinhardt, Günther, Dipl.-Ing., Von-der-Sitt-Strasse 13a, D-8450 Amberg (DE)**

## Beschreibung

Die Erfindung bezieht sich auf eine aus einzelnen Baugruppen zusammengesetzte elektrische Anlage mit einem Baugruppenträger, an dem Steckanschlüsse befestigt sind, die mit Gegensteckanschlüssen von Baugruppen durch Aufschwenken in Verbindung bringbar und danach mechanisch gehalten sind.

Bei einer bekannten Anlage der obengenannten Art (DE-C-28 10 071) ist eine Normtragschiene vorgesehen, über die die Steckanschlüsse geschnappt sind und über eine Busleitung miteinander verbunden sind. Die einzelnen Baugruppen werden mit einer Nase hinter den einen Schenkel der Normtragschiene geführt und durch Einschwenken mit den in der Baugruppe vorgesehenen Gegenanschlüssen auf die Steckanschlüsse aufgebracht und mit dem anderen Schenkel der Tragschiene verrastet.

Der Erfindung liegt die Aufgabe zugrunde, diese bekannte Anordnung hinsichtlich der Halterung und Zuordnung der Busanschlüsse auch bei unterschiedlich breiten Baugruppen, zu verbessern.

Dies wird auf einfache Weise dadurch erreicht, dass der Baugruppenträger aus einer Profilplatte besteht, die an der Einschwenklagerseite U-Profil hat, von dem der eine Schenkel entsprechend der Baugruppenbreite Einschnitte aufweist und der andere, kürzere, der Baugruppe zugewandte Schenkel als Schwenkachse für die Baugruppe dient, und dass den kürzeren U-Schenkel umgreifende Führungsplatten für die Seitenführung der Baugruppe mit Schnapparmen in die Einschnitte einschnappbar sind.

Hierdurch ergibt sich auch eine gute Seitenführung für die einzelnen Baugruppen. Ausserdem ist eine grössere Variabilität hinsichtlich der Busleitungen gegeben.

Um eine sichere Halterung der Baugruppen auch bei extremen Erschütterungen und zwar unabhängig von der vorherigen Festlegung des Einbauplatzes, zu gewährleisten ist es vorteilhaft, wenn die Profilplatte eine C-Nut zum Einführen von Einlegemuttern aufweist, die zwischen den Führungsplatten in Nutlängsrichtung gehalten sind.

Um die Lage der Einlegemuttern in bezug auf die Baugruppe festzulegen, jedoch gewisse Toleranzen beim Einführen der zugeordneten Befestigungsschrauben zuzulassen, ist es vorteilhaft, wenn die Muttern in Nutlängsrichtung von Ausknackungen einer Mutternschiene lose gehaltert sind. Die hier verwendeten Muttern können normale, handelsübliche Muttern sein. Die Mutternschiene ist ein einfaches Stanzbiegeteil. Eine Halterung der Mutternschiene in der Nut und damit der zugehörigen Muttern an einer bestimmten Stelle lässt sich erreichen, wenn eine Mutter mittels eines eingedrehten Gewindestiftes in der Nut verspannt ist.

Um auf einfache Weise festzustellen, ob die Baugruppe nach Einschwenken ordnungsgemäss befestigt wurden, ist es weiterhin vorteilhaft, wenn die den Einlegemuttern zugeordneten Befestigungsschrauben für die Baugruppen entgegen der Einschiebrichtung federbelastet geführt sind und über die Frontseite der Baugruppen im nicht eingedrehten Zustand überragen. Die die Baugruppe überragenden Befestigungsschrauben dienen nicht nur der Anzeige, sondern auch als Ausziehhilfe. Sie garantieren eine sichere Kontaktierung der Baugruppe mit den rückseitigen Anschlüssen und damit die Rüttel- und Schocksicherheit hinsichtlich der elektrischen Kontaktierung. Ohne Einschnitte, Ringe und Andrehungen für die Halterung der Befestigungsschrauben kann ausgekommen werden, wenn die Befestigungsschrauben angepresste Ohren haben und in kreisförmig endenden Rastausnehmungen an der Baugruppe gehalten sind. Durch Schrägstellen des Bolzens ist das Einführen und Herausnehmen der Befestigungsschrauben bei schlitzförmiger Ausbildung der Rastausnehmungen und maximal zwei gegenüberliegenden Ohren auch möglich, wenn der Befestigungsseite zugeordnet ein Durchgangsloch für die Befestigungsschraube vorhanden ist. Eine weitere einfache Halterung der den Baugruppen zugeordneten Steckanschlüsse an der Profilplatte ergibt sich, wenn eine die Steckanschlüsse tragende Leiterplatte in an der Profilplatte angeformten Tragleisten vorgesehenen Nuten einführbar sind. Durch die Leiterplatte ist eine vielseitige elektrische Verbindung zwischen den einzelnen Baugruppen möglich.

Um auch den Einbau von Baugruppen mit unterschiedlichen Gegensteckanschlüssen auf der erfindungsgemässen Profilplatte zu ermöglichen, ist es weiterhin vorteilhaft, wenn auf der Leiterplatte entsprechend dem Teilungsmass Anbaumöglichkeiten für unterschiedliche Steckanschlüsse vorgesehen sind. Hierdurch wird die Vielseitigkeit der Verwendung der erfindungsgemässen Profilplatte weiter erhöht.

Wenn zu erwarten ist, dass während des Betriebes Baugruppen mit unterschiedlichen Gegensteckanschlüssen Verwendung finden sollen, so kann die Profilplatte auch werksmässig mit den unterschiedlichen Steckanschlüssen, die innerhalb einer Teilung vorgesehen sind, versehen werden.

Um die Halterung auch hinsichtlich der elektrischen Verbindung, insbesondere hinsichtlich des externen Massekontaktes zu verbessern, ist es vorteilhaft, wenn an der Profilplatte eine Nut zum Einlegen des einen Endes einer Fingerfeder vorgesehen ist. Sie ermöglicht das Einlegen der Fingerfeder an der für die einzusetzende Baugruppe notwendigen Stelle, wobei durch Verquetschen der Nut die Feder mechanisch gehaltert und elektrisch mit der Profilplatte noch besser kontaktiert wird. Durch das Verquetschen reisst eine eventuelle vorhandene Oxydschicht auf, was einer Kaltverschweissung ähnlich einer Crimpverbindung gleichkommt. Hierzu ist es weiterhin vorteilhaft, wenn die Fingerfeder an dem einen Ende gefaltet ist bzw. die Fingerfeder im Bereich der Nut Ausnehmungen aufweist. Eine Oberflächenbehandlung der Profilplatte kann durch die Kaltverschweissung zwischen Fingerfeder und Profilplatte entfallen. Wenn die Baugruppe im Bereich der Fingerfeder mit einer Kontaktierungsfahne für die Leiterplatte versehen ist, kann eine Oberflächenbehandlung des Baugruppengehäuses entfallen.

Anhand der Zeichnung wird ein Ausführungsbeispiel gemäss der Erfindung beschrieben und die Wirkungsweise näher erläutert.

Es zeigen:

Fig. 1 eine perspektivische Darstellung der elektrischen Anlage mit der Profilplatte als Baugruppenträger und einer vom Baugruppenträger entfernten Baugruppe,

Fig. 2 eine Seitenansicht, zum Teil im Schnitt, durch die Profilplatte mit den Steckanschlüsse tragende Leiterplatten, die in der Profilplatte angeformten Tragleisten vorgesehenen Nuten eingeführt sind,

Fig. 3 eine Teildraufsicht auf die Tragplatte bei entfernten Baugruppen,

Fig. 4 eine Seitenansicht auf die Profilplatte mit eingesetzten Fingerfedern,

Fig. 5 eine Schnittdarstellung im Bereich der Fingerfeder nach dessen Einquetschung,

Fig. 6 eine Schnittdarstellung von in die Nut eingelegten Einlegemuttern mit Mutternschiene und

Fig. 7 eine perspektivische Darstellung der Mutternschiene mit eingelegten Einlegemuttern.

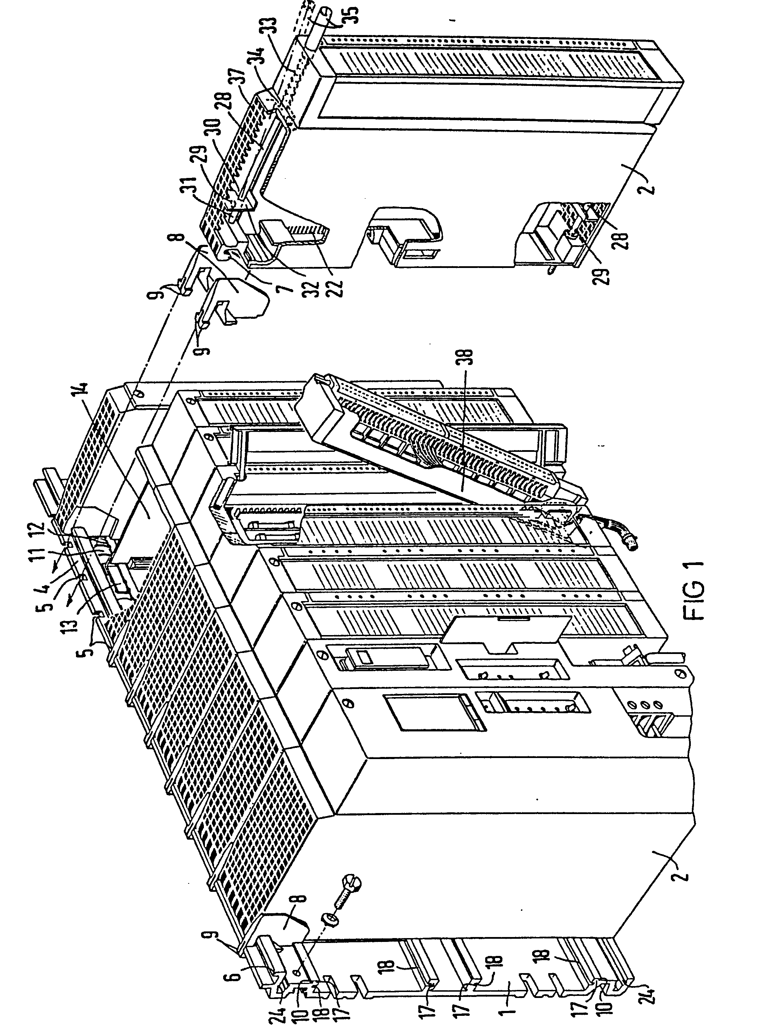

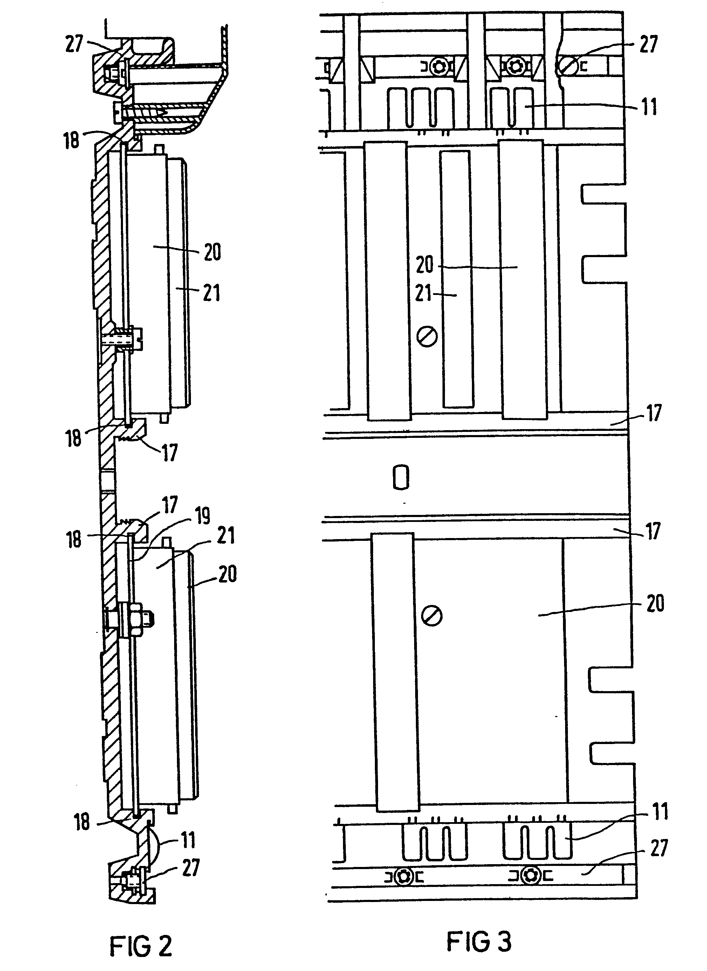

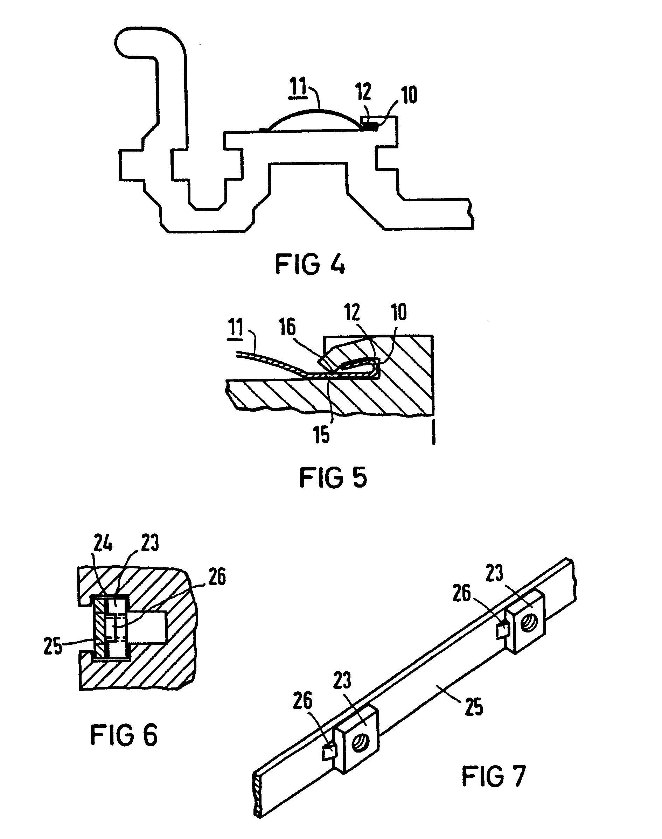

Die aus Fig. 1 ersichtliche elektrische Anlage besteht aus dem als Profilplatte 1 ausgebildeten Baugruppenträger, an dem die Baugruppen 2 befestigt sind. Die Profilplatte 1 hat an der Einschwenklagerseite ein U-Profil 3, von dem der eine Schenkel 4 entsprechend der Baugruppenbreite der Baugruppen 2 Einschnitte 5 aufweist. Der kürzere Schenkel 6 des U-Profils 3 dient als Schwenkachse für die Schwenklagerung 7 der Baugruppen 2. Den kürzeren Schenkel 6 umgreifend sind Führungsplatten 8 für die Seitenführung der Baugruppen 2 vorgesehen, die mit Schnapparmen 9 in die Einschnitte 5 des Schenkels 4 einschnappbar sind. In eine Nut 10 an der Frontseite der Profilplatte ist eine Fingerfeder 11 mit dem einen Ende 12 eingeschoben. Sie ist in der oberen rechten Hälfte im Anschlussbereich der zweiten Baugruppe 2 zu erkennen. Die Befestigung der Fingerfeder 11 wird anhand der Fig. 4 und 5 beschrieben. Sie wirkt zusammen mit einer Kontaktierungsfahne 13, die mit dem Massekontakt der Leiterplatte 14 der Baugruppen 2 als externer Massekontakt verbunden ist. Die Nut 10 ist im oberen und unteren Bereich der Profilplatte 1 vorhanden. Die Fingerfeder 11 ist an dem einen Ende 12 gefaltet ausgeführt, wie die Fig. 4 und 5 zeigen, und mit Ausnehmungen 15 ausgestattet, in die Teile 16 der Nutenkanten der Nut 10 eingedrückt werden können, wie es aus Fig. 5 zu ersehen ist, so dass ein sicherer und oxydfreier Kontakt zwischen Fingerfeder 11 und Profilplatte 1 hergestellt ist. In an die Profilplatte angeformte Tragleisten 17 sind Nuten 18 eingebracht, in die — wie Fig. 2 zeigt — Leiterplatten 19 eingeschoben sind, die mit Steckanschlüssen 20 bzw. 21 in elektrische und mechanische Verbindung gebracht sind und die elektrische Verbindung der einzelnen Baugruppen untereinander übernehmen. Die Steckanschlüsse 20 und 21 sind unterschiedlich ausgeführt, so dass Baugruppen mit unterschiedlichen Gegensteckanschlüssen, die in der Baugruppe 2 an der Leiterplatte 14 angebracht sind und mit 22 bezeichnet sind, auf die Profilplatte 1 aufgebracht werden können. Zur sicheren Halterung der Baugruppen 2 an der Profilplatte 1, auch bei Schockbeanspruchungen, dienen Einlegemuttern 23, die in C-Nuten 24 der Profilplatte 1 zusammen mit einer Mutternschiene 25 eingeschoben werden. Die Einlegemuttern 23 werden in Nutlängsrichtung von Ausknackungen 26 der Mutterschiene 25 lose gehaltert, so dass eine gewisse Beweglichkeit der Einlegemuttern in Längsrichtung gewährleistet ist. Die Fixierung der Mutternschiene in Längsrichtung erfolgt über einen in eine Einlegemutter eingedrehten Gewindestift 27, der die Mutter in der Nut verspannt und hiermit die Mutternschiene in Längsrichtung hält. In die Einlegemuttern 23 werden Befestigungsschrauben 28 zur Halterung der Baugruppen eingedreht. Die Befestigungsschrauben 28 haben angepresste Ohren 29, die auf zwei einander gegenüberliegenden Seiten der nur im unteren Bereich mit Gewinde versehenen Befestigungsschraube vorgesehen sind. Kreisförmige Rastausnehmungen 30 die in Form eines Schlitzes enden, dienen zur Halterung der Befestigungsschrauben im Gehäuse der Baugruppen 2. Nach Schrägstellen können sie in die Bohrung 31 am Boden der Baugruppe 2 eingeführt werden und die Ohren hinter dem die Rastausnehmung 30 aufweisenden Steg 32 geschoben werden und nach Zurückführen in die aus Fig. 1 ausgezogen dargestellte Lage der Befestigungsschraube 28 unter Anlage der Feder 33 am Steg 34 des Gehäuses in die aus Fig. 1 ersichtliche Lage mit dem der Anzeige bzw. Handhabe dienenden Teil 35, der über die Kontur der Baugruppe hinausgeht, gebracht werden. Zum Einlegen kann die Abdeckung 36 und die Seitenwand 37 der Baugruppe 2 abgenommen werden. Der Schraubenkopf der unteren Schraube 28 verhindert das Einschwenken der Steckanschlussleiste 38, sofern die Schraube 28 nicht eingedreht ist.

**Patentansprüche**

1. Aus einzelnen Baugruppen (2) zusammengesetzte elektrische Anlage mit einem Baugruppenträger (1), an dem Steckanschlüsse (20, 21) befestigt sind, die mit Gegensteckanschlüssen (22) der Baugruppen (2) durch Aufschwenken in elektrische Verbindung bringbar und die danach auch mechanisch gehalten sind, dadurch gekennzeichnet, dass der Baugruppenträger aus einer Profilplatte (1) besteht, die an der Einschwenklagerseite ein U-Profil (3) hat, von dem der eine, längere Schenkel (4) im Abstand entsprechend der Baugruppenbreite Einschnitte (5) aufweist und der andere, kürzere, der Baugruppe (2) zugewandte Schenkel (6) als Schwenkachse für die Baugruppe (2) dient, und dass den kürzeren U-Schenkel (6) umgreifende Führungsplatten (8) für die Seitenführung der Baugruppe (2) mit Schnapparmen (9) in die Einschnitte (5) einschnappbar sind.

2. Anlage nach Anspruch 1, dadurch gekennzeichnet, dass die Profilplatte (1) eine C-Nut (24) zum Einführen von Einlegemuttern (23) aufweist, die zwischen den Führungsplatten (8) in Nutlängsrichtung gehalten sind.

3. Anlage nach Anspruch 2, dadurch gekennzeichnet, dass die Einlegemuttern (23) in Nutlängsrichtung von Ausknackungen (26) einer Mutternschiene (25) lose gehalten sind.

4. Anlage nach Anspruch 3, dadurch gekennzeichnet, dass eine Einlegemutter (23) mittels eines eingedrehten Gewindestiftes (22) in der C-Nut (24) verspannt ist.

5. Anlage nach Anspruch 2, 3 oder 4, dadurch gekennzeichnet, dass die den Einlegemuttern (23) zugeordneten Befestigungsschrauben (28) für die Baugruppen (2) entgegen der Eindrehrichtung federbelastet (33) geführt sind und über die Frontseite der Baugruppen (2) im nicht eingedrehten Zustand überragen.

6. Anlage nach Anspruch 5, dadurch gekennzeichnet, dass die Befestigungsschrauben (28) angepresste Ohren (29) haben und in kreisförmig endenden Rastausnehmungen (30) an der Baugruppe (2) gehalten sind.

7. Anlage nach einem der vorhergehenden Ansprüche, dadurch gekennzeichnet, dass eine die Steckanschlüsse (20, 21) tragende Leiterplatte (19) in an der Profilplatte (1) angeformten Tragleisten (17) vorgesehenen Nuten (18) einführbar sind.

8. Anlage nach einem der vorhergehenden Ansprüche, dadurch gekennzeichnet, dass auf der Leiterplatte (19) entsprechend dem Teilungsmass Anbaumöglichkeiten für unterschiedliche Steckanschlüsse (20, 21) vorgesehen sind.

9. Anlage nach einem der vorhergehenden Ansprüche, dadurch gekennzeichnet, dass an der Profilplatte (1) eine weitere Nut (10) zum Einleiten des einen Endes (12) einer Fingerfeder (11) vorgesehen ist.

10. Anlage nach Anspruch 9, dadurch gekennzeichnet, dass die weitere Nut (10) im Bereich der Fingerfeder (11) verquetscht ist.

11. Anlage nach Anspruch 9 oder 10, dadurch gekennzeichnet, dass die Fingerfeder (11) an dem einen Ende (12) gefaltet ist.

12. Anlage nach Anspruch 9, 10 oder 11, dadurch gekennzeichnet, dass die Fingerfeder (11) im Bereich der weiteren Nut (10) Ausnehmungen (15) aufweist.

13. Anlage nach einem der Ansprüche 9 bis 12, dadurch gekennzeichnet, dass die Baugruppe (2) im Bereich der Fingerfeder (11) mit einer Kontaktierungsfahne (13) für die Leiterplatte (14) versehen ist.

## Claims

1. Electrical installation comprising individual assemblies (2) and having an assembly carrier (1) to which there are secured plug or socket type connections (20, 21) which may be electrically connected with mating plug or socket type connections (22) of the assemblies (2) by means of the latter swivelling on the assembly carrier, and which assemblies are subsequently also held mechanically, characterised in that the assembly carrier comprises a profiled plate (1) which, on the swivel bearing side, has a U-profile (3) of which the one longer side (4) has notches (5) at a distance apart in accordance with the width of the assembly, and the other, shorter, side (6) facing the assembly (2) serves as a swivel axis for the assembly (2), and in that, encompassing the shorter U-side (6), guide plates (8) for the lateral guidance of the assembly (2) may be snapped into the notches (5) with snap arms.

2. Installation according to claim 1, characterised in that the profiled plate (1) has a C-groove (24) for the introduction of insert nuts (23) which are held between the guide plates (8) in the longitudinal direction of the groove.

3. Installation according to claim 2, characterised in that the insert nuts (23) are held loosely in the longitudinal direction of the groove by stamped-out portions (26) of a nut rail (25).

4. Installation according to claim 3, characterised in that an insert nut (23) is braced by means of a screwed-in threaded pin (22) in the C-groove (24).

5. Installation according to claim 2, 3 or 4, characterised in that the securing screws (28) for the assemblies (2), associated with the insert nuts (23), are guided in spring-loaded manner (33) in opposition to the screw-in direction, and project over the front side of the assemblies (2) in the non-screwed-in state.

6. Installation according to claim 5, characterised in that the securing screws (28) have lugs (29) pressed thereon and are held on the assembly (2) in circularly ending stop recesses (30).

7. Installation according to one of the preceding claims, characterised in that a printed circuit board (19) bearing the plug or socket type connections (20, 21) can be introduced into grooves (18) provided in mounting strips (17) pre-formed on the profiled plate (1).

8. Installation according to one of the preceding claims, characterised in that there are provided on the printed circuit board (19), in accordance with the degree of division, possibilities for attaching different plug-type connections (20, 21).

9. Installation according to one of the preceding claims, characterised in that a further groove (10) is provided on the profiled plate (1) for the insertion of one (12) of the ends of a finger spring (11).

10. Installation according to claim 9, characterised in that the further groove (10) is squeezed in the region of the finger spring (11).

11. Installation according to claim 9 or 10, characterised in that the finger spring (11) is folded at the one end (12).

12. Installation according to claim 9, 10 or 11, characterised in that the finger spring (11) has recesses (15) in the region of the further groove (10).

13. Installation according to one of claims 9 to 12, characterised in that the assembly (2) is provided with a contacting lug (13) for the printed circuit board (14) in the region of the finger spring (11).

## Revendications

1. Installation électrique composée de modules (2) séparés, comprenant un porte-modules (1) sur lequel sont fixées des connexions à enfichage (20, 21) qui peuvent être amenées en liaison électrique avec des connexions complémentaires (22) des modules (2) par rabattement des modules par pivotement sur le porte-modules, et qui sont ensuite également maintenues mécaniquement, caractérisée en ce que le porte-modules est formé d'une plaque profilée (1) qui possède un profil en U (3) du côté du palier de pivotement pour le rabattement, profil en U dont une aile (4), qui est plus longue que l'autre, présente des encoches (5) avec un espacement correspondant à la largeur des modules et dont l'autre aile (6), dirigée vers le module (2), sert d'axe de pivotement pour le module (2), et que des plaques de guidage (8) entourant l'aile (6) plus courte du profil en U et servant au guidage latéral du module (2), peuvent être encliquetées par des bras d'accrochage (9) dans les encoches (5).

2. Installation selon la revendication 1, caractérisée en ce que la plaque profilée (1) présente une rainure en C (24) pour l'insertion d'écrous (23) qui sont maintenus entre les plaques de guidage (8) dans le sens de la longueur de la rainure.

3. Installation selon la revendication 2, caractérisée en ce que les écrous insérés (23) sont maintenus avec jeu, dans le sens de la longueur de la rainure, par des ergots (26) formés par repoussage dans un rail à écrous (25).

4. Installation selon la revendication 3, caractérisée en ce qu'un écrou inséré (23) est bloqué dans la rainure en C (24) au moyen d'un goujon fileté (22) vissé dans l'écrou.

5. Installation selon la revendication 2, 3 ou 4, caractérisée en ce que les vis (28) coordonnées aux écrous insérés (23), vis qui servent à la fixation des modules (2), sont guidées en étant chargées élastiquement (33) en sens contraire au vissage et font saillie du côté frontal des modules (2) lorsqu'elles ne sont pas vissées dans les écrous.

6. Installation selon la revendication 5, caractérisée en ce que les vis de fixation (28) possèdent des oreilles (29) à pression de serrage et sont maintenues sur le module (2) dans des évidements d'arrêt (30) se terminant en arc de cercle.

7. Installation selon une des revendications précédentes, caractérisée en ce que les connexions à enfichage (20, 21) sont portées par une plaque à circuits imprimés (19) qui est insérée dans des réglettes de support (17) formées sur la plaque profilée (1).

8. Installation selon une des revendications précédentes, caractérisée en ce que des possibilités de montage pour différentes connexions à enfichage (20, 21) sont prévues sur la plaque à circuits imprimés (19), conformément au pas de division de celle-ci.

9. Installation selon une des revendications précédentes, caractérisée en ce que la plaque profilée (1) présente une rainure supplémentaire (10) pour l'insertion de l'une des extrémités (12) d'un ressort-lame bombé (11).

10. Installation selon la revendication 9, caractérisée en ce que la rainure supplémentaire (10) est comprimée par matage dans la région du ressort-lame (11).

11. Installation selon la revendication 9 ou 10, caractérisée en ce que le ressort-lame (11) est replié à ladite extrémité (12).

12. Installation selon la revendication 9, 10 ou 11, caractérisée en ce que le ressort-lame (11) présente des évidements (15) dans la région de la rainure supplémentaire (10).

13. Installation selon une des revendications 9 à 12, caractérisée en ce que le module (2) est pourvu d'une languette de contact (13) pour la plaque à circuits imprimés (14) dans la région du ressort-lame (11).

0 162 373

FIG 1

FIG 2

FIG 3

FIG 4

FIG 5

FIG 6

FIG 7